Europäisches Patentamt

European Patent Office

Office européen des brevets

(11) Publication number: **0 436 297 A2**

# EUROPEAN PATENT APPLICATION

(21) Application number: 90312863.5

(51) Int. Cl.5: **H01L 27/06, H01L 21/82**

(22) Date of filing: 27.11.90

(30) Priority: 04.12.89 US 445530

(43) Date of publication of application:
10.07.91 Bulletin 91/28

(84) Designated Contracting States:
BE DE FR GB IT

(71) Applicant: RAYTHEON COMPANY
141 Spring Street
Lexington Massachusetts 02173(US)

(72) Inventor: Feist, Wolfgang M.
2 Lido Avenue
Burlington, Massachusetts(US)

(74) Representative: Jackson, David Spence et al
REDDIE & GROSE 16, Theobalds Road
London, WC1X 8PL(GB)

(54) **Small BiCMOS transistor.**

(57) A structure forming a MOSFET and BJT transistor for a BiCMOS integrated circuit allows both transistors to be fabricated in a relatively small space. Size reduction is achieved by forming the inactive base region of the BJT and the drain of the MOSFET with one doped region (32). Additionally, the collector (24) of the BJT and the source of the MOSFET (34) are contiguously formed, thereby eliminating the space occupied by an insulator. Metal contacts (42a, 42b, 42c) are provided on silicide layers over the continguous collector (24) and source (34), the gate, and the emitter (28) respectively. The emitter (28) is formed in polysilicon immediately above the active base (22). A resistive film (44) may be applied over an insulative side wall shoulder (38c) to couple the emitter contact (42c) to a silicide layer (40c) over the drain (32).

EP 0 436 297 A2

# SMALL BICMOS TRANSISTOR

## Background of the Invention

This application relates generally to integrated circuits and more particularly to the logic family known as BiCMOS which contains both bipolar junction transistors and CMOS transistors.

The importance of integrated circuits in modern life is well known. Integrated circuits are fabricated by forming numerous transistors on a semiconductor chip and then interconnecting the transistors. In operation, the transistors switch on and off to perform a desired function.

It is often desirable for the transistors making up the integrated circuit to have various properties. For example, it is often desirable for the transistors to dissipate small amounts of power. CMOS transistors are widely used where low power dissipation is important. In other instances, fast switching between the on and off states is important. In those instances, bipolar transistors are often used.

In other instances, both speed and power are important. A logic family called BiCMOS logic has been developed to construct integrated circuits. In a BiCMOS integrated circuit, CMOS transistors and bipolar transistors are connected to operate as one transistor switch. In this way, low power dissipation and fast switching times may be achieved. One drawback of BiCMOS logic is that two transistors are required to perform the same function as one transistor in either CMOS or bipolar logic. As a result, BiCMOS logic circuits are larger than either bipolar or CMOS logic circuits.

## Summary of the Invention

With the foregoing background in mind, it is an object of this invention to provide a layout for a bipolar and a CMOS transistor in a BiCMOS integrated circuit which allows the two transistors to be constructed close together.

The foregoing and other objects are achieved by a structure in which some of the regions of the CMOS transistor are merged with regions of the bipolar transistor. In particular, the inactive base of the bipolar transistor and the drain of the CMOS transistor are formed by one doped region. Further, the collector of the bipolar transistor and the source of the CMOS transistor are made contiguous, thereby saving the space ordinarily required for some means to isolate them.

## Brief Description of the Drawings

The invention will be better understood by reference to the following more detailed description and accompanying drawings in which

FIG. 1 is a schematic of a prior art BiCMOS inverter; and

FIGS. 2A to 2E are cross-sectional views of the steps in fabricating, according to the invention, a portion of the inverter in FIG. 1.

## Description of the Preferred Embodiment

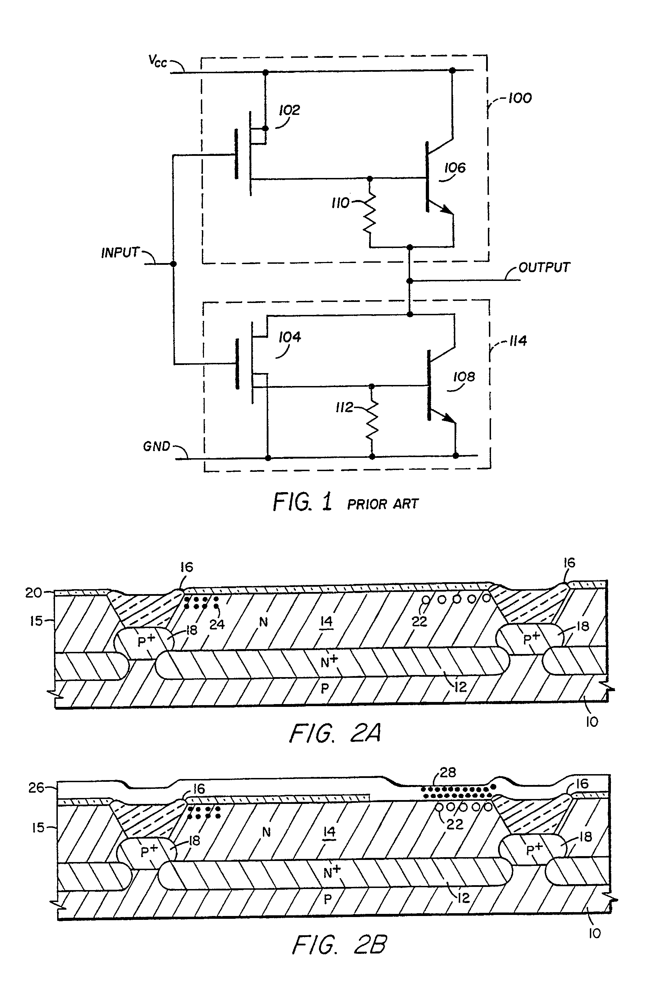

FIG. 1 shows a schematic of a BiCMOS inverter as known in the art. In the fabrication of integrated circuits, numerous such inverters are connected to perform the desired logic function. As is known, an inverter consists of an upper section 100 and a lower section 114. When a logic HI signal is applied to the INPUT, lower section 114 connects the OUTPUT to ground, GND. Conversely, when a logic LO is applied to the INPUT, upper section 110 connects the OUTPUT to the positive supply $V_{CC}$. In this way, a logic HI at the INPUT produces a logic LO at the OUTPUT and a logic LO at the INPUT produces a logic HI at the OUTPUT.

Upper section 100 and lower section 114 each perform the function of one transistor in a bipolar or CMOS inverter. In the BiCMOS inverter of FIG. 1, each of sections 100 and 114 contains one CMOS transistor and one bipolar transistor. As shown, upper section 100 contains a p-channel MOSFET and an npn bipolar junction transistor (hereafter "BJT"). Lower section 114 contains an n-channel MOSFET and an npn BJT. The drains of MOSFETs 102 and 104 are connected to the bases of BJTs 106 and 108, respectively. This configuration provides lower power dissipation since MOSFETs 102 and 104 only require an input current when the INPUT changes. BJTs 106 and 108 provide the large transductance needed for fast switching times.

In a conventional BiCMOS circuit, MOSFETs 102 and 104 and BJTs 106 and 108 are fabricated in electrically isolated regions of a semiconductor substrate. The various terminals of the transistors are then connected together as shown in FIG. 1, typically using metal traces.

FIGS. 2A-2E show how both MOSFET 102 and BJT 106 of upper section 100 (FIG. 1) can be fabricated in one electrically isolated region. In this way, the total area on the semiconductor substrate occupied by upper section 100 can be reduced.

FIG. 2A shows the cross-section of one electrically isolated region of a semiconductor chip. An epitaxial layer 15 is grown, using known techniques, on p-type substrate 10 to a thickness of approximately 1.5-2.0 $\mu$m. Epitaxial layer 15 is doped in a known manner with n-type impurities to form collector region 14. Substrate 10 is doped to a dopant concentration on the order of $10^{15}$ atoms/cm³. The doping concentration of epitaxial layer 15 is between $5 \times 10^{15}$/cm³ and $1 \times 10^{17}$/cm³.

An electrically isolated region is formed by p + regions 18 and oxide regions 16. The n-type doping of collector region 14 creates a reversed biased p-n junction with p + type regions 18, and p-type substrate 12. The oxide regions 16 are nonconductive. Thus, an electrically isolated region is defined by the interface between collector region 14 and oxide regions l6, p + regions 18 and substrate 10. Of course, other methods of providing an electrically isolated region are well known and could alternatively be used.

Subcollector 12 is a heavily doped n⁺ region commonly found in BJT circuits. It is typically formed before epitaxial layer 15 is grown. Subcollector 12 reduces the lateral resistance in the electrically isolated collector region 14. Subcollector 12 may, however, be omitted.

A thin oxide layer 20 is then grown over electrically isolated region 14. Oxide layer 20 is grown to a thickness of about 100-250Å in any conventional manner.

Two doped regions are then formed by implanting ions through oxide layer 20. Active base region 22 is formed by implanting boron to form a p-type region. Boron ions are implanted at $1 \times 10^{13}$/cm² at 30KeV. Collector contact region 24 is formed by ion implanting phosphorus to form an n + -type region. The phosphorus ions are implanted at approximately $4 \times 10^{15}$/cm² at 160KeV.

It is well known how to dope selective regions of a semiconductor structure such as is required to form active base region 22 and collector contact region 24. Briefly, a photoresist layer is formed over the structure. Selective regions of the structure are exposed to light, which chemically alters those regions. When exposed to certain chemicals, the altered regions dissolve, leaving the selected regions of the semiconductor structure exposed. The remaining photoresist material "masks" the rest of the structure.

A photoresist mask is also used to protect one portion of oxide layer 20 while the portion of oxide layer 20 above active base region 22 is removed. As shown in FIG. 2B, oxide layer 20 can be etched away slightly beyond active base region 22.

Next, an undoped polysilicon layer 26 is grown over the structure. Polysilicon layer 26 is deposited to a thickness of approximately 2500Å in any known manner.

A portion of polysilicon layer 26 above active base region 22 is doped to make an n⁺-type emitter region 28. Again, this selective doping is accomplished with a photoresist mask. Here, arsenic ions are implanted at $5 \times 10^{15}$ to $1 \times 10^{16}$/cm² at 80 KeV.

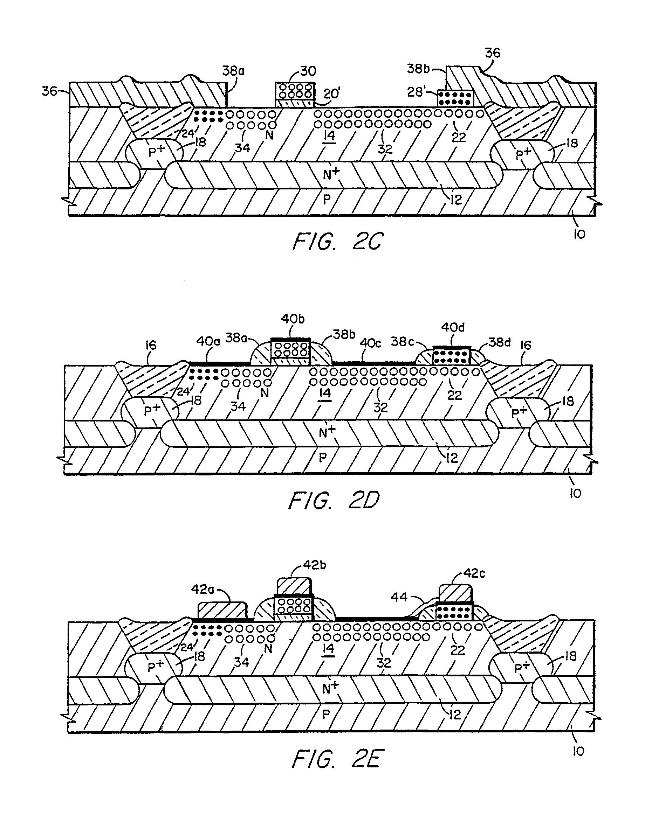

As shown in FIG. 2C, emitter polysilicon 26 is etched to form emitter region 28'. For example, reactive ion etching could be used. Active base region 22 extends beyond all sides of emitter region 28'. During the etching of polysilicon layer 26, gate region 30 is also formed.

Emitter region 28' and gate region 30 are formed by masking those two regions with photoresist and etching the rest of polysilicon layer 26. One simple way to determine how long to etch the polysilicon layer is by observing or measuring the color change of the semiconductor structure during the etching. As the etching removes the polysilicon, the silicon below it is exposed and the color of the structure changes. The color change, thus, indicates the required amount of the polysilicon has been removed. With that photoresist mask in place, the remainder of oxide layer 20 is also removed, leaving only oxide layer 20'.

Next, a photoresist layer is formed and patterned to mask emitter region 28' and collector region 24. The placement of edges 38a and 38b of photoresist layers is not critical. Edge 38a must be such that a major portion of collector region 24 is covered by photoresist mask 36. Edge 38b must be located such that most of emitter region 28' is covered by photoresist mask 36. Also, edge 38b must be placed such that a portion of active base region 22 is not covered by photoresist mask 36.

With photoresist mask 36 in place, the structure is doped. First silicon ions are implanted at a dose of $1.6 \times 10^{15}$/cm² at 45KeV. Next, boron as BF₂ is implanted into the structure to form p + -type source region 34 and drain region 32. It should be noted that drain region 32 is in contact with active base region 22 and provides a connection to it. Thus, drain region 32 also performs the function of what is commonly called the inactive base region. Also, the boron implant dopes gate region 30 p +. The boron implant is performed at about $5 \times 10^{14}$/cm² at 40KeV. The implanted silicon amorphizes portions of the epitaxial layer 15, thereby preventing channeling of the boron.

Turning to FIG. 2D, sidewall spacers 38a-38d are next formed. To form sidewall spacers 38a-38d, a conformal layer of silicon oxide is deposited onto the structure, preferably about 200Å thick. The silicon oxide is then vertically or anisotropically etched, such as by reactive ion etching, to leave sidewall spacers 38a-38d.

With the sidewall spacers 38a-38d in place, silicide contacts 40a to 40d are formed. To form silicide, a metal such as titanium or cobalt is deposited over the structure. Through heating, the metal is reacted with silicon or polysilicon, but not silicon oxide, to form silicide. The unreacted metal over sidewall spacers 38a-39d and oxide spacers 16 can then be dissolved, such as by using 1:1 $H_2SO_4/H_2O_2$ solution to dissolve titanium or 3:1 HCl/ $H_2O_2$ solution to dissolve cobalt.

FIG. 2E shows that metal contacts 42a-42c can be formed over silicide contacts 40a, 40b and 40d. These contacts reduce the vertical resistance of the silicide contacts 40a, 40b and 40d, as well as provide a means to connect the BiCMOS transistors to other parts of the integrated circuit (not shown). Contact 42b is the connection to the gate, which is the INPUT of FIG. 1. Contact 42c is the connection to the emitter, which is connected to the OUPUT in FIG. 1. Contact 42a is connected to both the source and collector, which is connected to the positive supply voltage $V_{CC}$ in FIG. 1.

To complete the structure of FIG. 1, resistor 110 can be formed by depositing a resistive film 44 over sidewall spacer 38c. Resistive film 44 can be deposited in any known manner.

Having described one embodiment of the invention, it will be apparent to one of skill in the art that numerous alternative embodiments can be constructed. For example, the structure described combined a p-channel MOSFET and an n-p-n BJT. An n-channel MOSFET and a p-n-p BJT could likewide be combined. As a further example, other fabrication techniques could be used. Many methods of doping and patterning regions in a semiconductor are known. It is felt, therefore, that this invention should be limited only by the spirit and scope of the appended claims.

## Claims

1. In an integrated circuit of the type having transistors formed in electrically isolated regions, an improvement comprising:
   a) a MOSFET formed in an electrically isolated region; and
   b) a BJT formed in the same electrically isolated region as the MOSFET.

2. The integrated circuit of Claim 1 wherein the base of the BJT is contiguous with the drain of the MOSFET.

3. The integrated circuit of Claim 1 wherein the collector of the BJT is contiguous with the source of the MOSFET.

4. The integrated circuit of Claim 2 wherein the collector and source are electrically connected by a silicide layer on the surface of the electrically isolated region.

5. The integrated circuit of Claim 1 wherein the MOSFET is a p-channel MOSFET and the BJT is an n-p-n transistor.

6. The integrated circuit of Claim 1 wherein the MOSFET is an n-channel MOSFET and the BJT is a p-n-p transistor.

7. The integrated circuit of Claim 3 wherein the emitter of the BJT comprises a doped polysilicon region on a surface of the electrically isolated region.

8. The integrated circuit of Claim 7 additionally comprising a resistive film contacting both the drain of the MOSFET and the emitter of the BJT.

9. A semiconductor structure formed in a semiconductor region with a first type doping, said structure comprising:
   a) a first region having a second doping type formed over a first portion of a surface of the semiconductor region;
   b) a second region having the first doping type formed over a portion of the semiconductor region;
   c) a third region having the second type doping formed in the semiconductor region below the second region;
   d) a fourth region having the second type doping formed in the semiconductor region contiguous with the third region and adjacent the first region and the second region;
   e) a fifth region formed in the semiconductor region adjacent the first region and on an opposite side of the first region than the fourth region; and
   d) a sixth region having the first type doping formed in the semiconductor region adjacent the fifth region.

10. The semiconductor structure of Claim 9 wherein the fifth region is electrically connected to the sixth region.

11. The semiconductor structure of Claim 10 additionally comprising first insulative sidewall spacers adjacent to and contiguous with the first region.

12. The semiconductor structure of Claim 11 additionally comprising second insulative sidewall spacers adjacent to and contiguous with the second region.

13. The semiconductor structure of Claim 12 additionally comprising a layer of insulative material disposed between the first region and the surface of the semiconductor region.

14. The semiconductor structure of Claim 13 additionally comprising a first silicide region over the second region.

15. The semiconductor structure of Claim 14 additionally comprising a second silicide region over the surface of the semiconductor region between the first region and the second region.

16. The semiconductor structure of Claim 15 additionally comprising a resistive film, a first portion of said film being contiguous with the first silicide region, a second portion of said film being contiguous with the second silicide region, and a third portion of said film being contiguous with a portion of said second insulative sidewall spacers.

17. A method of forming a semiconductor structure in a region of an integrated circuit chip, comprising:
a) disposing a layer of insulative material over the region of the integrated circuit;
b) implanting a first type dopant into a first region of the region of the integrated circuit;
c) implanting a second type dopant into a second region of the region of the integrated circuit;
d) removing a portion of the insulative material over the second region to form a window;
e) disposing a layer polysilicon over the region of the integrated circuit;
f) doping the polysilicon layer with a first type dopant over the window;
g) patterning the polysilicon layer to form a first region containing the doped polysilicon and a second region; and
h) implanting dopant of the second type into the second region of polysilicon, a region of the integrated circuit between the first and second regions of polysilicon, and into a region of the integrated circuit between the second region of polysilicon and the first region of the region of the integrated circuit.

18. The method of Claim 18 additionally comprising forming a silicide layer over both a) the first region of the region of the integrated circuit; and b) the implanted dopant between the second region of polysilicon and the first region of the region of the integrated circuit.

19. The method of Claim 18 wherein the step of forming a silicide layer additionally comprises:
a) forming a silicide layer over the first region of the polysilicon; and
b) forming a silicide layer over the region of the integrated circuit between the first region of the polysilicon and the second region of the polysilicon.

20. The method of Claim 19 additionally comprising the step of forming a resistive film contacting both:
a) the silicide layer over the first region of the polysilicon; and
b) the silicide layer over the region of the integrated circuit between the first region of the polysilicon and the second region of the polysilicon.

$V_{CC}$

102

100

106

110

INPUT

OUTPUT

104

114

108

112

GND

FIG. 1  PRIOR ART

16

16

20

15

18

24

N

14

22

18

P+

N+

P

12

10

FIG. 2A

28

26

16

16

18

N

14

22

18

15

P+

P+

N+

P

12

10

FIG. 2B

FIG. 2C

FIG. 2D

FIG. 2E